# EUROPEAN PATENT SPECIFICATION

(11) **EP 4 135 127 B1**
(45) Date of publication and mention of the grant of the patent: **05.11.2025**
(21) Application number: 22191324.7
(22) Date of filing: 23.09.2015
(51) Int. Cl.: H01Q 3/26, G02F 1/13, H01L 21/48, H01L 21/66, H01L 23/538, H01L 25/075, G02F 1/1345, G02F 1/136, G09G 3/32, G09G 3/00, H01Q 1/22, H01Q 21/00

(54) **COMPOUND MICRO-ASSEMBLY STRATEGIES AND DEVICES**
VERBUNDMIKROANORDNUNGSSTRATEGIEN UND -VORRICHTUNGEN
STRATÉGIES ET DISPOSITIFS DE MICRO-ASSEMBLAGE DE COMPOSÉS

(30) Priority: 25.09.2014 US 201462055472 P; 10.08.2015 US 201514822868
(43) Date of publication of application: 15.02.2023
(62) Divisional of application: 15780778.5
(73) Proprietor: X Display Company Technology Limited, Dublin D02 A342 (IE)
(72) Inventor: BOWER, Christopher, Cork (IE); MEITL, Matthew, Cork (IE)
(74) Representative: Graham Watt & Co LLP

(56) References cited:
- US-A- 4 322 735
- US-A- 4 330 329
- US-A1- 2011 067 911
- US-B2- 6 422 716
- US-B2- 7 479 731

## Description

### Background

Flat-panel displays are typically constructed with an array of light emitters distributed over a flat substrate surface. With the exception of plasma televisions, emissive flat-panel displays often rely on either (i) a backlight with pixel light control provided by liquid crystals and color filters (e.g., liquid crystal displays), (ii) organic colored light emitters (e.g., organic light emitting diode displays), or (iii) organic white-light emitters with color filters (e.g., white organic light emitting diode displays). Importantly, all three of these flat-panel display technologies are area emitters, that is, the entire area of each pixel is filled with the light emitter or light controller.

Light emitting diodes (LEDs) are typically manufactured using a semiconductor process requiring the use of various chemical materials. These manufacturing methods require the use of a rigid substrate, such as a sapphire substrate or a silicon substrate, that does not melt during the high-temperature manufacturing process. After fabricating the LEDs on the rigid substrate, the wafers are often cut up to form individual LEDs that may then be used in displays.

Early LED applications in displays include hand held calculators with numeric LED displays. More recently, LEDs have been integrated as backlights for displays. Integrating LEDs in larger displays, such as display panels, involves complex wiring to each individual LED in the display panel. The use of LEDs in displays, such as RGB LED displays, continues to present numerous challenges, including increased complexity, limited display format, increased manufacturing costs, and reduced manufacturing yields.

US 4,322,735 A discloses a display device with a relatively large insulation substrate with at least one pair of ceramic unit substrates having thereon metal layers bearing LEDs. A metal layer on the insulation substrate is connected with the metal layers on the unit substrates.

Thus, there is a need for systems and methods of manufacturing displays, as well as other devices such as photovoltaic arrays and radar arrays, that provide low cost manufacturing, improved yield, and improved reliability for the systems.

### Summary

The invention relates to compound micro-assembled devices as defined by the appended claims. References to "disclosure" and "examples" throughout the description which are not under the scope of the claims merely represent exemplary executions and are not part of the present invention.

The disclosed technology relates generally to designs and methods of assembling devices utilizing compound micro-assembly. Compound micro-assembly is a process in which micro-assembly - for example, the micro transfer printing process described in U.S. Patent Nos. 7,622,367 and 8,506,867 - is first used to assemble functional elements onto an intermediate substrate to form a functional (e.g., testable) micro-system. Then, the newly generated micro-system is micro-assembled onto the destination or device substrate to form an operational macro-system (e.g., the ultimate device). An array of micro-systems may be created in massive parallel and then micro-assembled onto the destination substrate.

For example, for the manufacture of a display device that employs compound micro-assembly, each micro-system may form an individual pixel. A plurality of pixels are formed and then micro-assembled onto the destination substrate. For example, device elements (e.g., red, green, and blue micro LEDs and a silicon drive circuit) can be formed in massive parallel on corresponding native substrates, then micro-assembled (e.g., via micro transfer printing) onto an intermediate substrate as a matrix of individual micro-systems, where each micro-system is a pixel containing LEDs (e.g., red, green, and blue micro LEDs) and a silicon drive circuit. The matrix of micro-systems on the intermediate substrate can be densely packed, thereby allowing for the necessary fine lithography to be conducted for all of the micro-systems over a smaller area, resulting in lower assembly cost and an improved product. Furthermore, the matrix of micro-systems on the intermediate substrate may be functional, allowing for testing, identification of faulty pixels, and/or repair of faulty pixels prior to assembly onto the macro-system (e.g., the final display), further improving the product. The known-good micro-systems (e.g., pixels) can then be transferred from the intermediate substrate to a destination substrate (e.g., via micro-transfer printing) to form one or more macro-systems (e.g., the ultimate device).

Micro-assembly is an advantageous strategy for combining the functionalities of dissimilar materials into heterogeneously integrated systems. The resulting micro-systems and macro-systems can have the appearance and properties of a monolithic unit due to the fine scales of the heterogeneity, and they can exhibit properties not otherwise accessible from the constituent material types or combinations of the constituents assembled by conventional means.

Furthermore, the compound micro-assembly process produces multi-functional heterogeneously integrated micro-scale elements (micro-systems) that provide the functional units of the array of a micro-assembled system (macro-system).

Among other things, the disclosed compound micro-assembly techniques allow for optimized combinations of lithography. Specifically, in certain embodiments, micro-systems are fabricated on a wafer and interconnected using state-of-the-art wafer-level lithography (fine lithography), for example having feature dimensions of less than or equal to 10 microns, less than or equal to 5 microns, less than or equal to 2 microns, or less than one micron. **In** contrast, crude lithography may be used to electrically connect to the micro-systems after they have been micro-assembled onto the destination substrate, for example having feature dimensions of greater than 10 microns, greater than or equal to 50 microns, greater than or equal to 100 microns, or greater than one millimeter.

Moreover, the micro-systems may be densely formed on a wafer such that the density of the micro-systems is greater on the wafer than when the micro-systems are micro-assembled on the destination substrate. Thus, using fine lithography when the micro-systems are on the wafer is more cost effective due to the high density of the micro-systems and crude lithography can be used after the micro-systems are printed to the destination substrate. Furthermore, the number of input/output lines formed on the macro-level (i.e., after transferring the micro-system to the destination substrate) for a given device is reduced relative to conventional non-compound assembly techniques.

The micro-systems may be wired on the intermediate substrate such that they are fully functional devices prior to being transferred to the destination substrate. This allows the micro-systems to be tested prior to micro-assembling them to the destination substrate. Defective micro-systems may be removed or irradiated (e.g., with a laser) such that only functional micro-systems are transferred to the destination substrate. Input/output lines may be routed on the anchors and tethers of the intermediate substrate to facilitate the testing. In other examples, each micro-system includes an antenna and/or solar cell that facilitate testing of the micro-system.

Thus, the benefits of the disclosed systems and methods of compound micro-assembly include, but are not limited to, reduced assembly costs and increased throughput, reduced I/O count at the macro-system, improved transparency, and improved performance.

A method of compound micro-assembly is disclosed but not claimed herein and is not part of the invention, the method including: providing a transfer device having a contact surface with a micro-system temporarily attached thereto, wherein the micro-system includes: an intermediate substrate, a plurality of micro-devices disposed on the intermediate substrate, and one or more fine interconnections electrically connected to at least a portion of the plurality of micro-devices, thereby electrically coupling the portion of the micro-devices;
contacting the micro-system disposed on the transfer surface with a receiving surface of a destination substrate; and separating the contact surface of the transfer device and the micro-system, thereby transferring the micro-system onto the receiving surface of the destination substrate.

The invention includes a compound micro-assembled device including: a plurality of printed micro-systems disposed on and non-native to a destination substrate, wherein each micro-system of the plurality of printed micro-systems includes: a plurality of micro-devices disposed on and non-native to an intermediate substrate, and one or more fine lithography interconnections electrically connecting the plurality of micro-devices on the intermediate substrate; and one or more crude lithography interconnections disposed on the destination substrate having a width from 2 µm to 2 mm, wherein each crude lithography interconnection is electrically connected to at least one of the plurality of micro-systems on the intermediate substrate.

**In** certain embodiments, the plurality of micro-devices includes: a red micro inorganic light emitting diode, a green micro inorganic light emitting diode, a blue micro inorganic light emitting diode, and a micro-integrated circuit.

In certain embodiments, the plurality of micro-devices comprises a second red micro inorganic light emitting diode, a second blue micro inorganic light emitting diode, and a second green micro inorganic light emitting diode.

In certain embodiments, each micro-system is a display pixel.

In certain embodiments, the over 300,000 micro inorganic light-emitting diodes.

In certain embodiments, the plurality of micro-devices includes: a power amplifier (e.g., GaN), a phase shifter (e.g., GaAs), and a micro-integrated circuit (e.g., silicon control circuit).

In certain embodiments, the plurality of micro-devices comprises at least one member selected from the group consisting of: a low-noise amplifier (e.g., InP), power amplifiers, analog-digital converters, transmit/receive switches, phase shifters, and frequency converters.

In certain embodiments, the plurality of micro-devices includes: a detector (e.g., photodiode, photoconductor), and a micro-integrated circuit (e.g., control/read-out circuit, e.g., silicon control circuit).

In certain embodiments, the destination non-native substrate is a member selected from the group consisting of polymer, plastic, resin, polyimide, PEN, PET, metal, metal foil, glass, a semiconductor, and sapphire.

In certain embodiments, the device comprises a matrix of at least 50,000 micro-systems on the destination substrate.

In certain embodiments, destination non-native substrate has a transparency greater than or equal to 50%, 80%, 90%, or 95% for visible light.

In certain embodiments, the destination substrate has a contiguous substrate area, the plurality of micro devices each have a device area, and the combined device areas of the plurality of micro devices is less than or equal to one-quarter of the contiguous substrate area.

In certain embodiments, the combined device areas of the plurality of micro devices is less than or equal to one eighth, one tenth, one twentieth, one fiftieth, one hundredth, one five-hundredth, one thousandth, one two-thousandth, or one ten-thousandth of the contiguous substrate area.

In certain embodiments, each of the plurality of micro devices has at least one of a length, width, and height from 2 to 5 µm, 5 to 10 µm, 10 to 20 µm, or 20 to 50 µm.

In certain embodiments, the destination substrate has a thickness from 5 to 10 microns, 10 to 50 microns, 50 to 100 microns, 100 to 200 microns, 200 to 500 microns, 500 microns to 0.5 mm, 0.5 to 1 mm, 1 mm to 5 mm, 5 mm to 10 mm, or 10 mm to 20 mm.

In certain embodiments, the plurality of micro devices are distributed over the contiguous substrate area (e.g., in an array).

Also disclosed but not claimed and not part of the invention is an apparatus including: a plurality of printed micro-systems, wherein each micro-system of the plurality of printed micro-systems includes: a plurality of micro-devices disposed on an intermediate substrate, non-native to the respective micro-devices of the micro-system, and one or more fine interconnections having a width of 100 nm to 2 µm, each fine lithography interconnection electrically connected to at least one of the plurality of micro-devices, wherein each micro-system of the plurality of micro-systems is partially released from the bulk intermediate substrate such that each micro-system of the plurality of micro-system is connected to the bulk intermediate substrate by a tether

### Brief Description of the Figures

The foregoing and other objects, aspects, features, and advantages of the present invention will become more apparent and better understood by referring to the following description taken in conjunction with the accompanying drawings, in which:
FIG. 1 is an illustration of an example selective dry transfer contact printing method for assembling printable semiconductor element on a receiving surface of a substrate;
FIGS. 2A-D illustrate an example flow chart with cross-section schematic views illustrating micro transfer printing using a shear offset;
FIG. 3 is an illustration of an example method of compound micro-assembly;
FIG. 4 is an illustration of an example method of compound micro-assembly;
FIG. 5 is a diagram of a method for micro-assembling a micro LED display;
FIGS. 6A-B is an illustration of compound micro-assembly of a micro LED display;
FIGS. 7A-B is an illustration of compound micro-assembly of a micro LED display;
FIGS. 8A-B illustrate of an example method of micro-assembling a micro inorganic-LED (ILED) display;
FIG. 9 illustrates micro-systems for a micro LED display;
FIG. 10 is an illustration of an example method of compound micro-assembling micro-devices to form a multifunctional system;
FIGS 11A-B are illustrations of example micro-systems;
FIG. 12 is an illustration of utilizing compound micro-assembly for phased array applications;
FIG. 13 is an illustration of an example micro-assembled micro-system that is a display pixel;
FIG. 14 is an illustration of an example micro-system that has been etched underneath the micro-system and remains attached to an anchor by a breakable tether;
FIGS. 15A-B are an example of micro-systems that have been printed to a destination substrate;
FIG. 16A is an illustration of a micro-system used in an embodiment of the invention;
FIG. 16B is an illustration of the micro-system micro-assembled on a substrate, in accordance with an embodiment of the invention;
FIG. 17A is an illustration of a micro-system used in an embodiment of the invention;
FIG. 17B is an illustration of the micro-system micro-assembled on a substrate, in accordance with an embodiment of the invention;
FIG. 18A is an illustration of a micro-system used in an embodiment of the invention;
FIG. 18B is an illustration of the micro-system micro-assembled on a substrate, in accordance with an embodiment of the invention; and
FIGS. 19A-G illustrate an example process for creating a micro-system.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements.

### Detailed Description

"Printing" refers to a process of transferring a feature, such as a semiconductor element, from a first surface to a second surface. In an aspect, the first surface is a donor surface and the second surface a receiving surface, and the transfer is mediated by an intermediate surface such as a stamp having a transfer surface. In an aspect, the first surface is a transfer surface on a stamp on which one or more semiconductor elements are supported, and the stamp is capable of releasing the elements to a receiving surface on a target substrate, thereby transferring the semiconductor element from the transfer surface of the stamp to the receiving surface on the target substrate. In an aspect, the printing is dry transfer printing of printable semiconductors, wherein the adhesive force between a solid object and the stamp surface is rate-sensitive.

As used herein the expression "semiconductor element" and "semiconductor structure" are used synonymously and broadly refer to a semiconductor material, structure, device, or component of a device. Semiconductor elements include high-quality single crystalline and polycrystalline semiconductors, semiconductor materials fabricated via high-temperature processing, doped semiconductor materials, organic and inorganic semiconductors, and composite semiconductor materials and structures having one or more additional semiconductor components or non-semiconductor components, such as dielectric layers or materials or conducting layers or materials. Semiconductor elements include semiconductor devices and device components including, but not limited to, transistors, photovoltaics including solar cells, diodes, light-emitting diodes, lasers, p-n junctions, photodiodes, integrated circuits, and sensors. In addition, semiconductor element refers to a part or portion that forms an end-functional semiconductor.

"Semiconductor" refers to any material that is a material that is an insulator at a very low temperature, but which has an appreciable electrical conductivity at a temperature of about 300 Kelvin. In the present description, use of the term semiconductor is intended to be consistent with use of this term in the art of microelectronics and electronic devices. Semiconductors useful in the present invention may comprise element semiconductors, such as silicon, germanium and diamond, and compound semiconductors, such as group IV compound semiconductors such as SiC and SiGe, group III-V semiconductors such as AlSb, AlAs, Aln, AlP, BN, GaSb, GaAs, GaN, GaP, InSb, InAs, InN, and InP, group III-V ternary semiconductors alloys such as AlxGa1-xAs, group II-VI semiconductors such as CsSe, CdS, CdTe, ZnO, ZnSe, ZnS, and ZnTe, group I-VII semiconductors CuCl, group IV-VI semiconductors such as PbS, PbTe and SnS, layer semiconductors such as PbI2, MoS2 and GaSe, oxide semiconductors such as CuO and Cu2O. The term semiconductor includes intrinsic semiconductors and extrinsic semiconductors that are doped with one or more selected materials, including semiconductor having p-type doping materials and n-type doping materials, to provide beneficial electronic properties useful for a given application or device. The term semiconductor includes composite materials comprising a mixture of semiconductors and/or dopants. Specific semiconductor materials useful for in some applications of the present invention include, but are not limited to, Si, Ge, SiC, AlP, AlAs, AlSb, GaN, GaP, GaAs, GaSb, InP, InAs, GaSb, InP, InAs, InSb, ZnO, ZnSe, ZnTe, CdS, CdSe, ZnSe, ZnTe, CdS, CdSe, CdTe, HgS, PbS, PbSe, PbTe, AlGaAs, AlInAs, AlInP, GaAsP, GaInAs, GaInP, AlGaAsSb, AlGaInP, and GaInAsP. Porous silicon semiconductor materials are useful for applications of the present invention in the field of sensors and light-emitting materials, such as light emitting diodes (LEDs) and solid state lasers. Impurities of semiconductor materials are atoms, elements, ions and/or molecules other than the semiconductor material(s) themselves or any dopants provided to the semiconductor material. Impurities are undesirable materials present in semiconductor materials which may negatively impact the electronic properties of semiconductor materials, and include but are not limited to oxygen, carbon, and metals including heavy metals. Heavy-metal impurities include, but are not limited to, the group of elements between copper and lead on the periodic table, calcium, sodium, and all ions, compounds, or complexes thereof.

"Substrate" refers to a structure or material on which, or in which, a process is conducted, such as patterning, assembly, or integration of semiconductor elements. Substrates include, but are not limited to: (i) a structure upon which semiconductor elements are fabricated, deposited, transferred, or supported; (ii) a device substrate, for example an electronic device substrate; (iii) a donor substrate having elements, such as semiconductor elements, for subsequent transfer, assembly or integration; and (iv) a target substrate for receiving printable structures, such as semiconductor elements.

The terms "micro" and "micro-device" as used herein refer to the descriptive size of certain devices or structures in accordance with embodiments of the invention. As used herein, the terms "micro" and "micro-device" are meant to refer to structures or devices having dimensions on the scale of 1 to 500 µm. In particular, micro-devices can have a width or length in the range of 1 to 500 microns, 50 to 500 microns, or 10 to 250 microns. The thickness of micro-devices is typically smaller than either the width or length of the device, for example less than 20 microns, less than 10 microns, or less than 5 microns. However, it is to be appreciated that embodiments of the present invention are not necessarily so limited, and that certain aspects of the embodiments may be applicable to larger or smaller size scales.

"Micro-system" as used herein refers to two or more micro devices arranged on an intermediate substrate for micro transfer printing onto a destination substrate. In an embodiment, the two-or-more micro devices are interconnected on the intermediate substrate with electrical conductors, such as wires. For example, a micro-system may be a red micro LED, a green micro LED, and a blue micro LED arranged on a plastic or glass substrate and interconnected using wires made by fine lithography. Micro-systems can be assembled (e.g., micro transfer printed) onto a destination substrate to form a macro system (e.g., a display).

"Intermediate substrate" refers to a substrate on which two or more micro-devices are arranged to form a micro-system. Specifically, the micro-devices are arranged on the intermediate substrate such that the entire micro-system (including the micro-devices and intermediate substrate) may be micro assembled onto a destination substrate.

"Destination" or "target" substrate as used herein refers to a substrate for receiving printable structures, such as semiconductor elements, micro-devices, or micro-systems. Example "destination" or "target" substrates include various plastics, glass, sapphire, as well as other transparent, semi-transparent, flexible, and semi-flexible materials.

"Fine" interconnections and lithography as used herein refers to the descriptive size of certain devices, interconnections, or structures in accordance with embodiments of the invention. As used herein, the terms "fine" are meant to refer to structures or devices on the scale of for example less than or equal to 10 microns, 5 microns, 2 microns, or one micron. However, it is to be appreciated that embodiments of the present invention are not necessarily so limited, and that certain aspects of the embodiments may be applicable to larger or smaller size scales.

"Crude" interconnections and lithography as used herein refers to the descriptive size of certain devices, interconnections, or structures in accordance with embodiments of the invention. As used herein, the terms "crude" are meant to refer to structures or devices on the scale of greater than 10 microns, greater than 100 microns, or greater than 500 microns. However, it is to be appreciated that embodiments of the present invention are not necessarily so limited, and that certain aspects of the embodiments may be applicable to larger or smaller size scales.

"Dielectric" and "dielectric material" are used synonymously in the present description and refer to a substance that is highly resistant to flow of electric current. Useful dielectric materials include, but are not limited to, SiO₂, Ta₂O₅, TiO₂, ZrO₂, Y₂O₃, SiN₄, STO, BST, PLZT, PMN, and PZT.

"Polymer" refers to a molecule comprising a plurality of repeating chemical groups, typically referred to as monomers. Polymers are often characterized by high molecular masses. Polymers useable in the present invention may be organic polymers or inorganic polymers and may be in amorphous, semi-amorphous, crystalline or partially crystalline states. Polymers may comprise monomers having the same chemical composition or may comprise a plurality of monomers having different chemical compositions, such as a copolymer. Cross-linked polymers having linked monomer chains are particularly useful for some applications of the present invention. Polymers useable in the methods, devices and device components of the present invention include, but are not limited to, plastics, elastomers, thermoplastic elastomers, elastoplastics, thermostats, thermoplastics and acrylates. Exemplary polymers include, but are not limited to, acetal polymers, biodegradable polymers, cellulosic polymers, fluoropolymers, nylons, polyacrylonitrile polymers, polyamide-imide polymers, polyimides, polyarylates, polybenzimidazole, polybutylene, polycarbonate, polyesters, polyetherimide, polyethylene, polyethylene copolymers and modified polyethylenes, polyketones, poly(methyl methacrylate, polymethylpentene, polyphenylene oxides and polyphenylene sulfides, polyphthalamide, polypropylene, polyurethanes, styrenic resins, sulphone based resins, vinyl-based resins or any combinations of these.

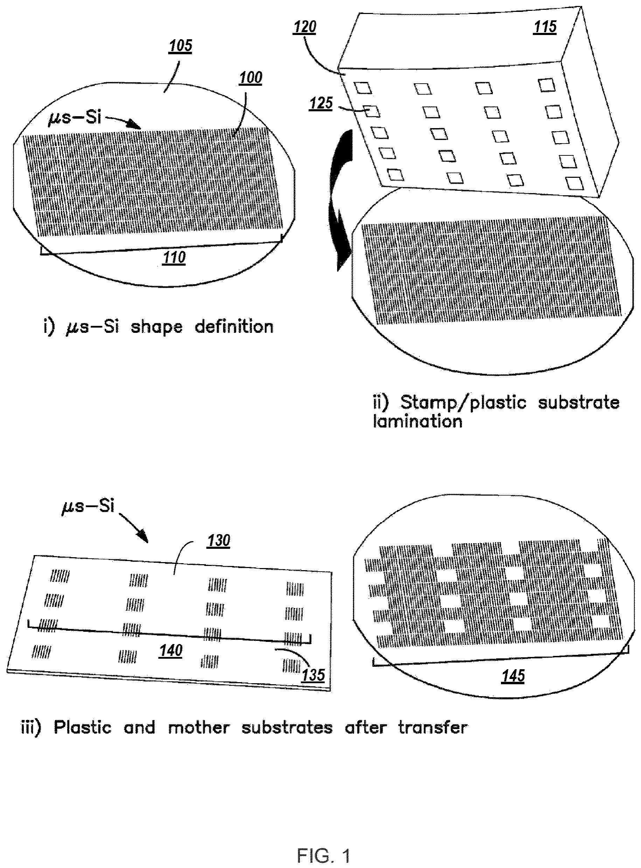

FIG. 1 provides a schematic diagram illustrating a selective dry transfer contact printing method for assembling printable semiconductor element on a receiving surface of a substrate as described in U.S. Patent No. 7,622,367. A plurality of printable semiconductor elements 100 are fabricated on a mother substrate 105 in a first pattern 110 of printable semiconductor elements 100 characterized by well-defined positions and spatial orientations. A conformable transfer device 115 having a contact surface 120 with a plurality of discrete binding regions 125 is brought into conformal contact with at least a portion of printable semiconductor elements 100 on mother substrate 105. Binding regions 125 on contact surface 120 are characterized by an affinity for printable semiconductor elements 100, and may be chemically modified regions, such regions having hydroxyl groups extending from the surface of a PDMS layer, or regions coated with one or more adhesive layers. Conformal contact transfers at least a portion of printable semiconductor elements 100 which contact binding regions 125 on contact surface 120. Printable semiconductor elements 100 transferred to contact surface 120 are brought into contact with receiving surface 130 of substrate 135, which may be a flexible substrate such as a plastic substrate. Subsequent separation of semiconductor elements 100 and contact surface 120 results in assembly of the semiconductor elements 100 on receiving surface 130 of substrate 135, thereby generating a second pattern 140 of printable semiconductor elements 100 characterized by well-defined positions and spatial orientations different from the first pattern 110 of printable semiconductor elements 100. As shown in FIG. 1, the printable semiconductor elements 100 that remain on mother substrate 105 are characterized by a third pattern 145 of printable semiconductor elements 100 different from first and second patterns 110, 140 of printable semiconductor elements 100. Printable semiconductor elements 100 comprising the third pattern 145 may be subsequently transferred to and/or assembled onto substrate 135 or another substrate using the printing methods of the present invention, including selective dry transfer methods.

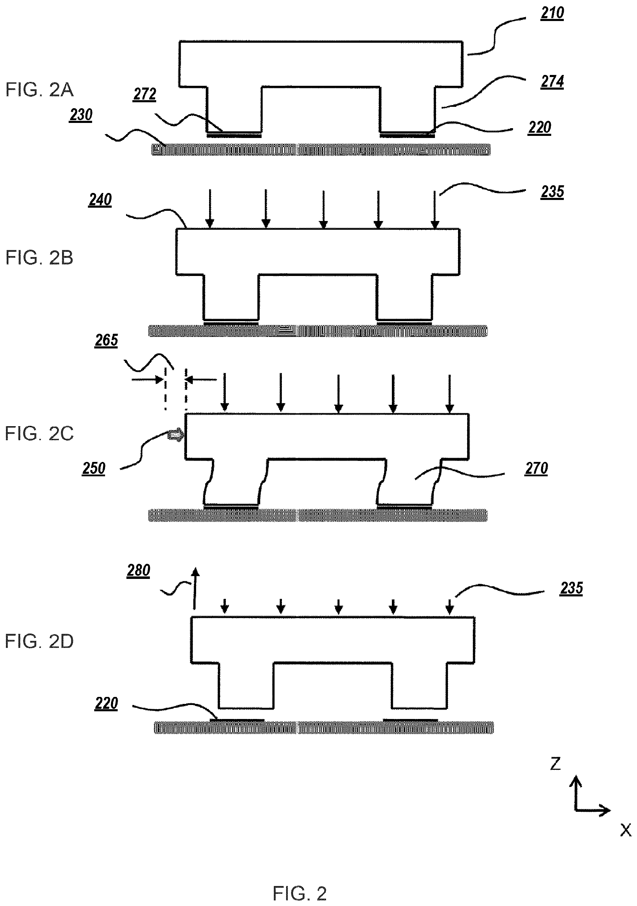

FIGS. 2A-D illustrates a method for controlling the delamination of a transfer printing stamp as discussed in U.S. Patent No. 8,506,867. First the stamp 210 is populated with an array of printable semiconductor elements 220 using standard procedures as described in published dry transfer printing literature (see, e.g., U.S. Pat. No. 7,622,367 to Khang et al.). In an aspect, the printable semiconductor elements 220 are on a printing surface 272 corresponding to an external surface of a three-dimensional pattern of relief features 274. The stamp is brought into close proximity (i.e. within less than or equal to 100 µm) to a receiving substrate surface 230 (FIG. 2A). After precise optical alignment of the stamp 210 to the receiving substrate 230, the stamp 210 is brought into conformal contact with the receiving substrate 230 by application of uniform air pressure 235 onto the stamp backing top surface 240 (FIG. 2B). Then, an in-plane shear force 250 (e.g., applied in a direction substantially parallel to the x-y plane) is applied to the stamp by moving the tool head apparatus (holding the stamp 210) by a precise displacement offset (away from the aligned position) 265 or to the receiving substrate 230 by a precise displacement of the receiving substrate 230 (FIG. 2C). **In** this aspect, the shear force or displacement 250 can be applied to the stamp 210, the receiving surface 230, or both, so long as the result is an in-plane displacement or shear offset 265 between the stamp 210 and the receiving surface 230, without prematurely entirely breaking conformal contact between the inked stamp 210 and the receiving surface 230, as shown in FIG. 2C. This shear force is transmitted to the stamp bottom surface, causing some elastic mechanical deformation of the stamp printing posts 270. Finally, the stamp 210 is delaminated from the receiving substrate 230 by moving the stamp 210 in the vertical (Z) direction 280 relative to the receiving surface 230 and simultaneously decreasing the air pressure 235 applied on the stamp backing (FIG. 2D). Vertical motion is indicated by the arrow 280 in the vertical direction where vertical motion can be controlled by moving the stamp 210, moving the receiving substrate 230, or moving both relative to each other. Decrease in air pressure is represented by the decrease in the magnitude of arrows 235 as compared to Fig. 2B.

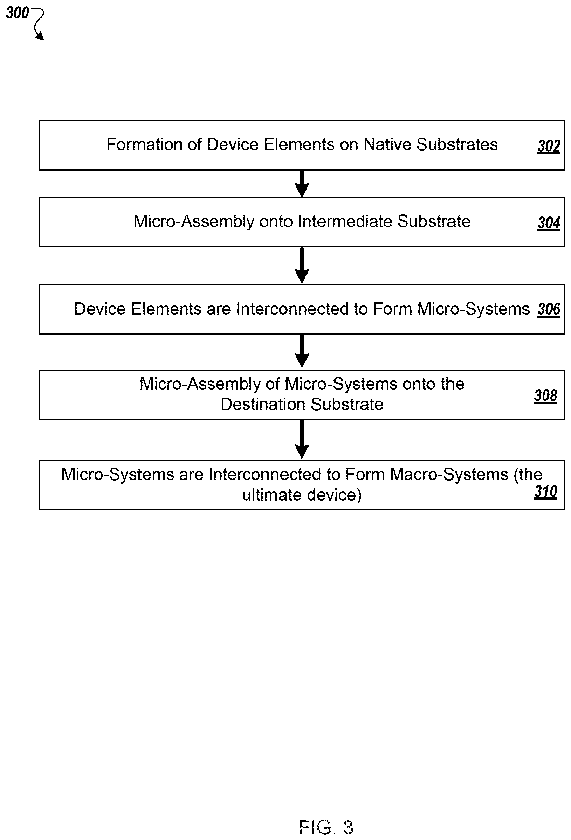

FIG. 3 is an illustration of an example method 300 of compound micro-assembly. In some implementations, devices are formed on native substrates (302). This may include forming a plurality of first micro-devices on a first native substrate and forming a plurality of second micro-devices on a second native substrate (e.g., different than the first native substrate). The micro-devices are then micro-assembled onto an intermediate substrate (304). For example, the plurality of first micro-devices and the plurality of second micro-devices may be micro-assembled on the intermediate substrate.

The micro-devices on the intermediate substrate are interconnected to form micro-systems (306). A complete set of different micro-devices makes up an individual micro-system. For example, each first micro-device may be electrically connected/coupled with a respective second micro-device using fine lithography (e.g., fine interconnections with a width of 100 nm to 10 µm), thereby forming a plurality of micro-systems. Additional micro-devices may be printed to the intermediate substrate and form part of the micro-system. The devices may be connected to each other or to an electricity source, to a data line, in rows, in columns, or in other ways as necessary for operation of the micro-system. Each micro-system, in this example, includes a portion of the intermediate substrate, a first micro-device, a second micro-device, and one or more fine interconnections electrically coupling respective first and second micro-devices (e.g., to each other or to other devices, sources, lines, and the like).

The micro-systems are then micro-assembled onto the destination substrate (308) and electrically connected in the appropriate configuration (e.g., specific to the application/device being produced) using crude lithography (e.g., interconnections with a width from 10 µm to 2mm), thereby forming a macro system (310).

In one example, compound micro-assembly techniques may be used to form a micro LED display. In this example, the micro-devices include red, green, and blue LEDs. The micro-devices may also include yellow LEDs, integrated circuits (e.g., drive circuits, such as silicon drive circuits), sensors, antennas, and/or solar cells. Integrated circuits, sensors, and solar cells are typically provided in silicon substrates, while light emitters are typically provided in other semiconductor materials, for example gallium nitride, aluminum gallium nitride, gallium arsenide, gallium arsenide phosphide, gallium phosphide, indium gallium nitride, or indium gallium phosphide. In this example, the micro-systems are assembled to form a display. The micro-systems, in some implementations, are individual pixels that are interconnected after transferring the appropriate number of pixels to the destination substrate.

**In** another example, compound micro-assembly techniques may be used to form phased-array antennas (e.g., beam-forming radar). **In** this example, the micro-devices may include power amplifiers (e.g., GaN based), low-noise amplifiers (e.g., **InP** based), phase shifters (e.g., GaAs based), or silicon control circuits. Each micro-system in this example is a control system for an individual antenna or cluster of antennae. The resulting macro-system is an antenna array and associated control systems that collectively form a beam-forming phased array.

**In** another example, compound micro-assembly techniques may be used to form detector arrays (e.g., x-ray detectors). The micro-devices in this example include detectors, such as photodiodes, photoconductors, etc., and control/read-out circuits (e.g., silicon-based circuits) typically provided in silicon substrates. The micro-systems are detector pixels that includes the detector and control/read-out element wired together. The macro system is a large-area detector formed from an array of interconnected pixels.

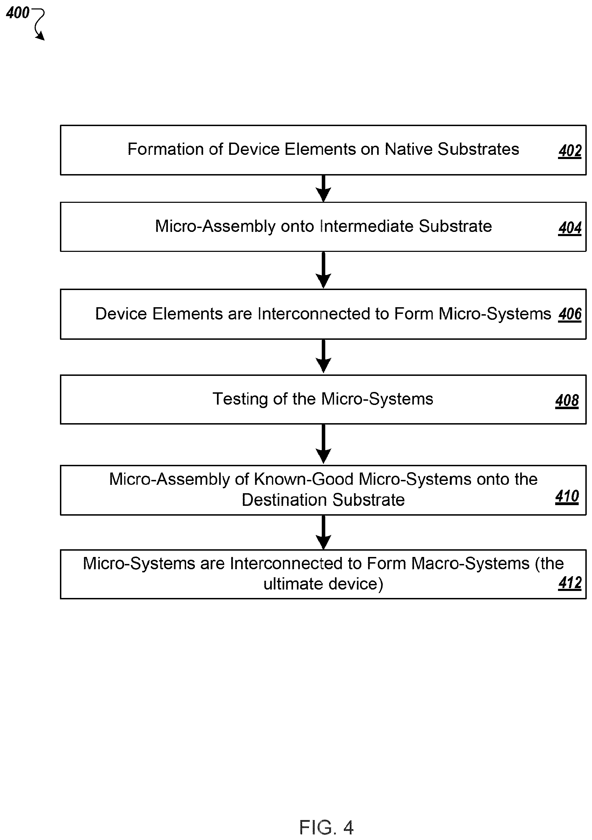

FIG. 4 is an illustration of an example method 400 of compound micro-assembly. **In** some implementations, devices are formed on native substrates (402). This may include forming a plurality of first micro-devices on a first native substrate and forming a plurality of second micro-devices on a second native substrate (e.g., different than the first native substrate). The micro-devices are then micro-assembled onto an intermediate substrate (404). For example, the plurality of first micro-devices and the plurality of second micro-devices may be micro-assembled onto the intermediate substrate.

The micro-devices on the intermediate substrate are interconnected to form micro-systems (406). The micro-systems may be interconnected such that each micro-system is fully functional. The micro-systems are then tested to verify they are functioning properly (408). In the example of a display formed using compound micro-assembly, each individual pixel may be tested to identify bad pixels prior to transferring the pixels to the destination substrate (e.g., glass, sapphire, plastic). Any defective micro-systems may be identified and removed or irradiated (e.g., with a laser, or mechanically removed by vacuum collets, elastomeric stamps, or picking tools such that they are not picked up by a transfer device.

The known-good micro-systems may be micro-assembled onto the destination substrate (410). Then, the micro-systems may be electrically connected (e.g., to each other and/or to other devices, sources, lines, and the like) using crude lithography, thereby forming a macro system (412). Crude lithography, in some implementations, provides interconnections with a width from 10 µm to 2 mm.

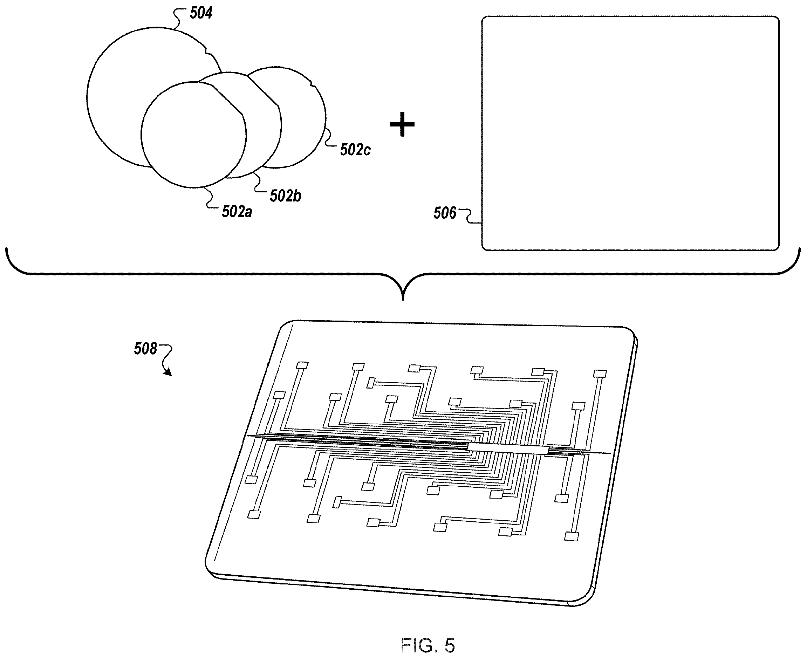

FIG. 5 is a diagram of a method for micro-assembling a micro LED display. Micro-assembly is an advantageous strategy for combining the functionalities of dissimilar materials into heterogeneously integrated systems. The resulting systems can have the appearance and properties of a monolithic unit due to the fine scales of the micro-assembled units, and they can exhibit properties not otherwise accessible from the constituent material types or a combinations of the constituents assembled by conventional means.

FIG. 5 illustrates the micro-assembly of integrated circuits 504 (e.g., silicon), a red LED 502c, green LED 502b, and blue LED 502a (e.g., RGB LEDs formed from III-V LED materials), and a glass or plastic substrate 506 to form a highly functional display 508. The resulting system exhibits the control and logic capabilities of silicon integrated circuits (ICs) 504, the efficient light generation of III-V LEDs 502, and the transparency of the glass (or plastic). Micro-assembly uniquely preserves the appearance of transparency by providing a practical means to prepare an array of components on the non-native substrate (e.g., glass or plastic) that are small enough to be effectively invisible. The resulting system 508 thus has a homogeneous appearance resembling a monolithic system.

Electronically steerable antennas (e.g., phased arrays) represent another type of system that benefits from micro-assembly, combining diverse combinations of RGB LEDs (e.g., group III-IV RGB LEDS) and other high-frequency devices with low-cost, large-area, optionally flexible substrates to produce an array with characteristics that are not practically accessible by conventional means.

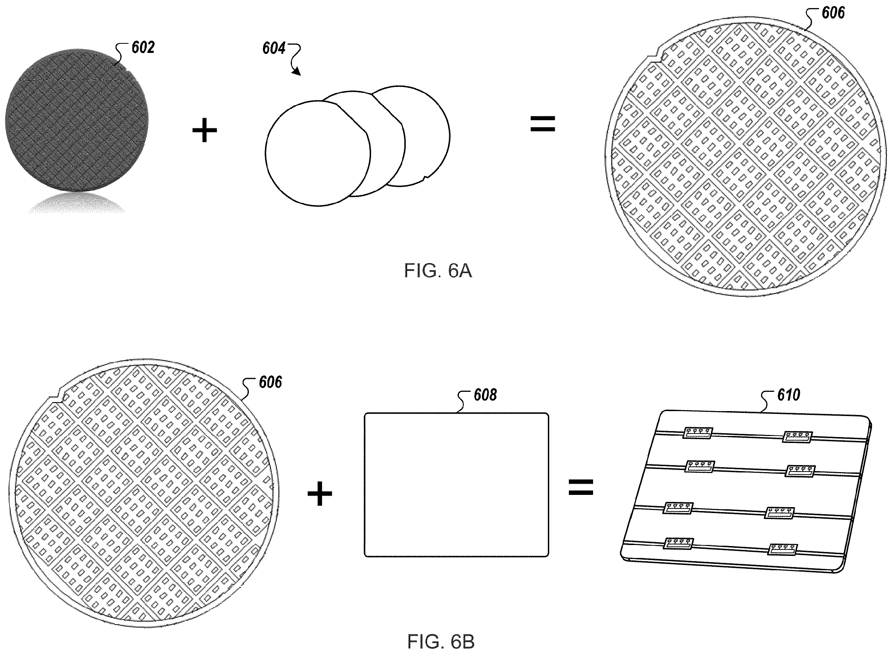

FIGS. 6A-6B are illustrations of compound micro-assembly of a micro-LED display. Some applications of micro-assembly that use diverse functionalities or materials benefit from a compound micro-assembly process. The compound micro-assembly process produces multi-functional heterogeneous integrated micro-scale elements (micro-systems) that provide the functional units of the array of a micro-assembled system (macro-system).

In display applications, micro-assembly techniques as shown in FIG. 6A form polyfunctional elements (micro-systems) 606 on a silicon-on-insulator substrate 602 that includes integrated-circuit functionalities by the addition of RGB LEDs 604 (e.g., group III-V RGB micro inorganic light emitting diodes). A second micro-assembly process as shown in FIG. 6B forms an array of the polyfunctional elements 606 onto the display device substrate 608, thereby forming a display (macro-system) 610 by compound micro-assembly. The benefits of compound micro-assembly include, but are not limited to reduced assembly costs and increased throughput, reduced I/O count at the macro-system, improved transparency, and increased performance. Moreover, micro-systems may be fabricated on a wafer and can be interconnected using state-of-the-art wafer-level lithography (e.g., fine lithography having dimensions less than or equal to 10 microns, less than or equal to 5 microns, less than or equal to 2 microns, or less than or equal to one micron). Fine lithography is cost effective for the micro-systems for a variety of reasons, including because the micro-systems are in a dense configuration on the wafer prior to being transferred to the destination substrate. Crude lithography having dimensions greater than 10 microns, greater than 100 microns, or greater than 1000 microns may be used to wire the micro-systems after they are transferred to the destination substrate. This is made possible because, among other reasons, larger conductive lines can be used on the destination substrate to connect to each micro-device and can be formed prior to transferring the micro-systems to the destination substrate.

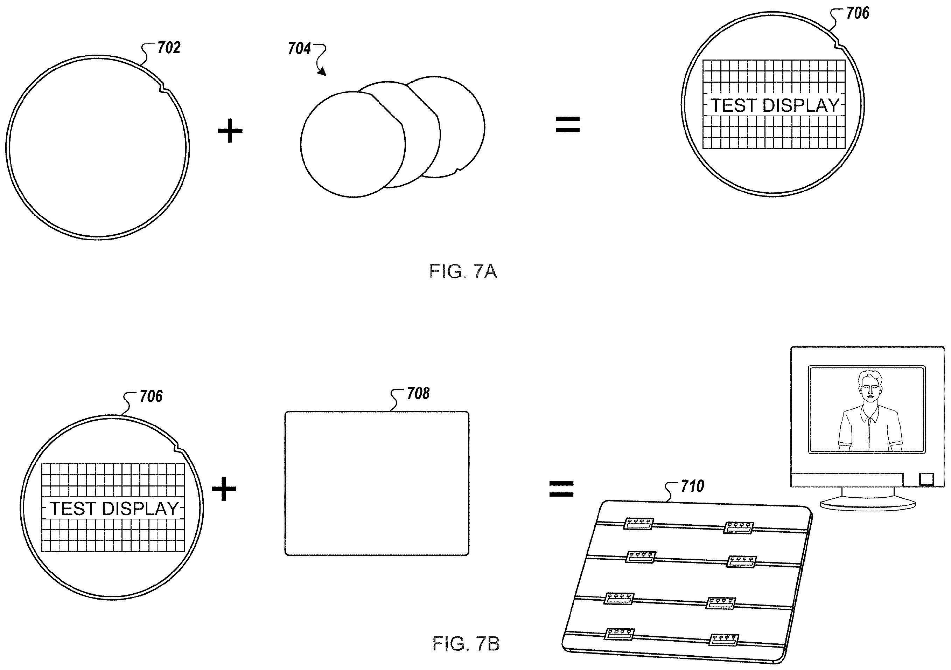

FIGS. 7A-7B are illustrations of compound micro-assembly of a micro LED display. The first micro-assembly as shown in FIG. 7A forms polyfunctional elements (micro-systems) 706 on a substrate 702 (e.g., silicon-on-insulator or glass) that includes integrated circuit functionalities by the addition of RGB LEDs 704 (e.g., group III-V RGB micro inorganic light emitting diodes).

In this example, the first micro-assembly generates a working ultra-high resolution display on the intermediate wafer as shown in FIG. 7A. Defective micro-assembled pixels (micro-systems) are detected and processes, such as removed or irradiated (e.g., with a laser), or mechanically removed by vacuum collets, elastomeric stamps, or picking tools are performed to prevent the defective pixels from being assembled onto the final substrate (e.g., display).

A second micro-assembly process as shown in FIG. 7B forms an array of the polyfunctional elements 706 on the display device substrate 708 (e.g., glass, plastic, or sapphire), thereby forming a display (macro-system) 710 by compound micro-assembly. In some implementations, the second micro-assembly process transfers the known-good micro-systems to the final device substrate as shown in FIG. 7B. Thus, compound micro-assembly allows for new ways of applying pixel testing to achieve high-yield displays.

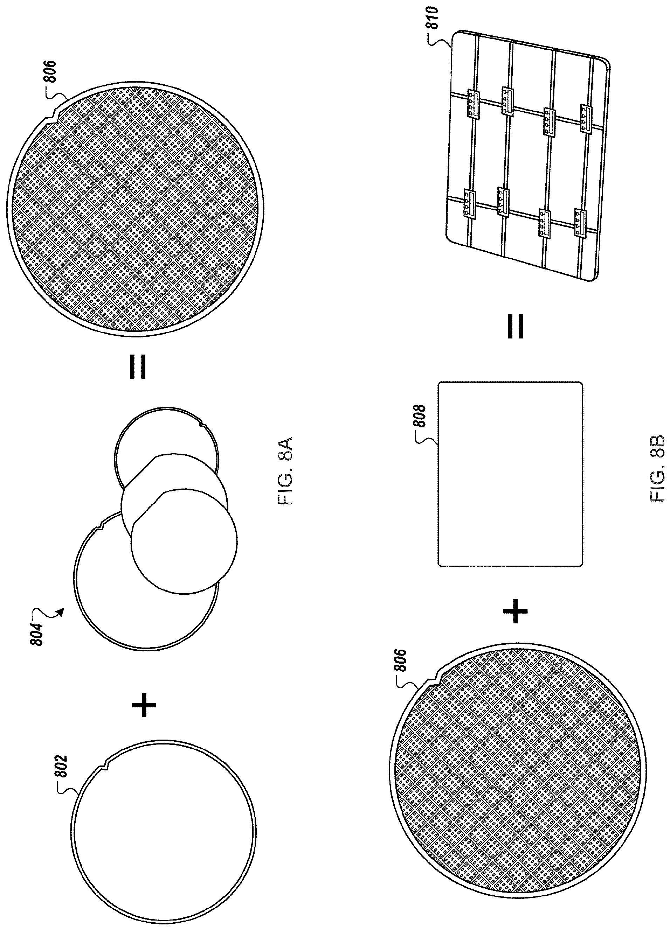

FIGS. 8A-8B illustrate an example method of micro-assembling a micro inorganic-LED ( micro-LED) display. In this example a monolithic multifunctional system (LED display 810) is formed by compound micro-assembly. Micro-assembly is used to produce polyfunctional integrated miniaturized elements (micro-systems) by placing diverse micro-scale components such as micro LEDs and micro-ICs 804 onto a support substrate 802 such as a glass wafer with a polymer film or a polymer wafer. Polyfunctional integrated transferable elements 806 may be subsequently formed on the support substrates, for example, by interconnection of the diverse micro-scale components on the support substrate. The micro-systems may be prepared for micro-assembly, for example, by tethering and releasing the transferrable elements (micro-systems) thereby creating the functional units of an inorganic light emitting diode display (macro-system). Tethering and releasing the micro-systems, in some implementations, includes etching at least a portion of the material supporting the micro-system such that the micro-system position or orientation of the micro-system is maintained by a tether. A second micro-assembly process as shown in FIG. 8B transfers arrays of the polyfunctional integrated elements (micro-systems) 806 from the support substrate to the display device substrate 808 (e.g. glass or polymer) during the formation of a micro LED display (macro-system) 810 by compound micro-assembly, for example by contacting elastomeric stamps to the top of the micro-system.

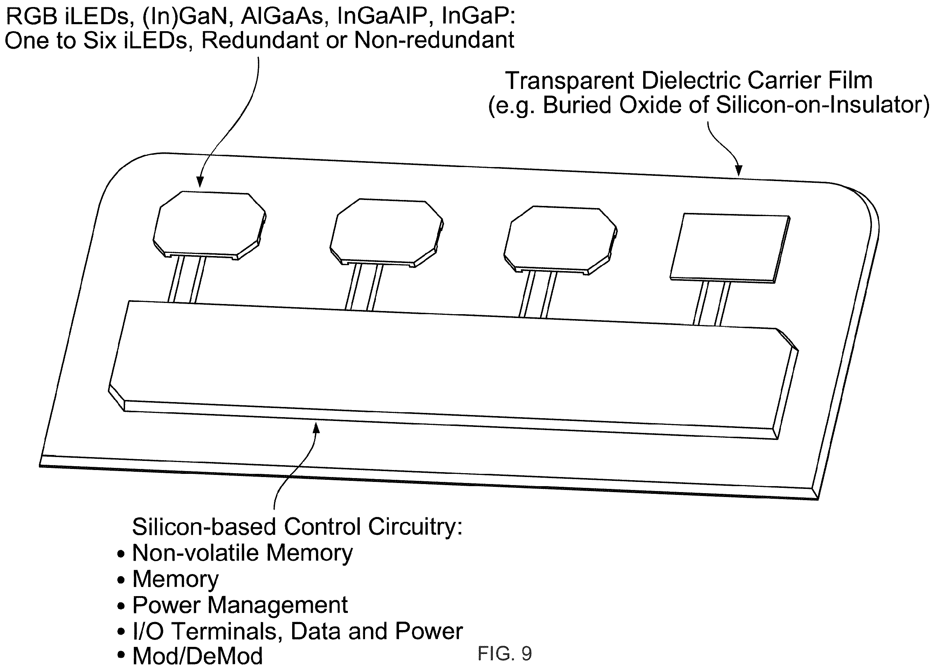

FIG. 9 illustrates micro-systems for a micro LED display. In some implementations, each micro-system forms a pixel for a display. Each pixel may contain a red micro LED, green micro LED, and blue micro LED. In some implementations, each pixel can contain a yellow or other additional color micro LED. In some implementations, each pixel also includes redundant micro LEDs (e.g., 6 micro LEDs in total for a RGB display). Additionally, in some implementations, each micro-system may include control circuitry (e.g., silicon-based control circuitry), such as non-volatile memory, memory, power management, input/output terminals, data lines, power lines, and/or modulation/demodulation systems. In some implementations, additional components may be provided in a micro-system, such as sensors, optical I/O, color convertors, and/or III-V power management components.

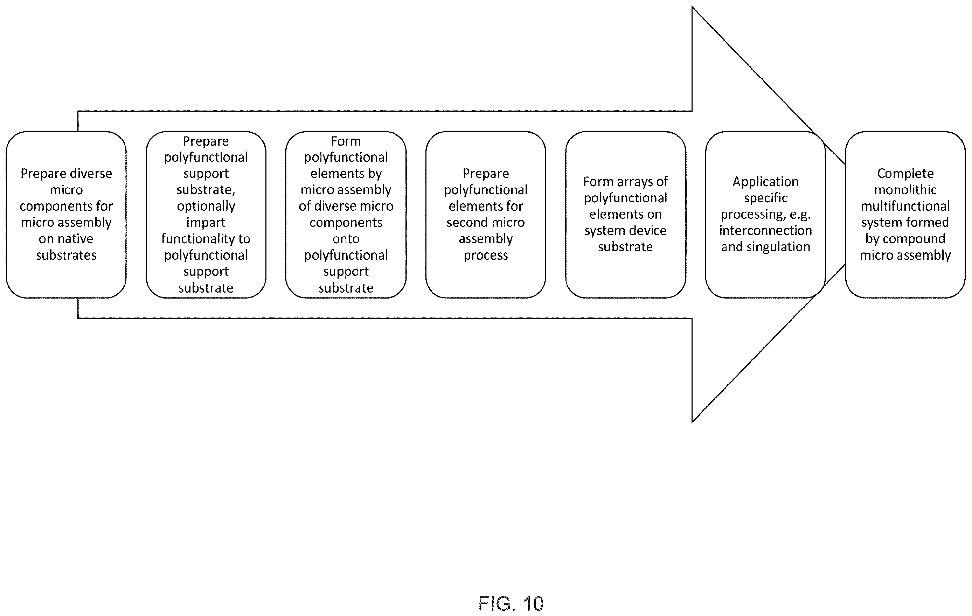

FIG. 10 is an illustration of an example method of compound micro-assembling micro-devices to form a multifunctional system. In some implementations, diverse microcomponents are prepared for micro-assembly on native substrates. The polyfunctional support substrate is prepared and functionality is imparted to the polyfunctional support substrate, for example by forming interconnections such as wires or contact pads, through-substrate interconnections (vias), or providing adhesive, curable, or insulating coatings, or providing passive components or structures on the support substrate. Polyfunctional elements (i.e., micro-systems) are formed by micro-assembly of diverse micro components onto the polyfunctional support substrate. The polyfunctional elements are then prepared for the second micro-assembly process. Arrays of polyfunctional elements are formed on system device substrates. After forming the arrays, in some implementations, application specific processing is performed, such as interconnection and singulation. The complete monolithic multifunctional system is then formed by compound micro-assembly.

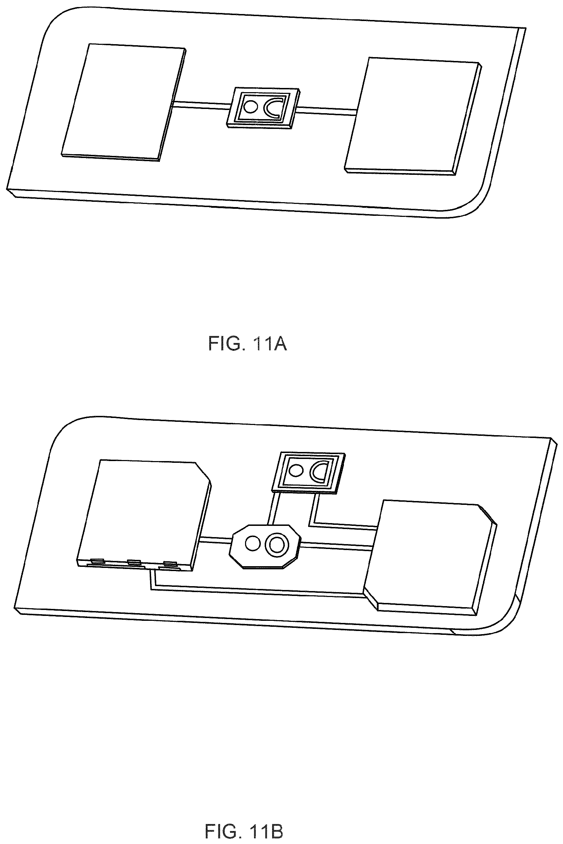

FIGS. 11A-11B are illustrations of example micro-systems. FIG. 11A is an illustration of a primitive micro-system and FIG. 11B is an illustration of a diverse micro-system. As shown in FIG. 11A, a micro-system may include a single active component including a support structure as well as interconnection features such as through-substrate interconnections. In contrast, as shown in FIG. 11B, a micro-system may include multiple active components and a support structure. For example, a diverse micro-system may include one or more of the following: micro LEDs, capacitors, antennae, integrated circuits, memory, photovoltaic cells, lasers, RF I/O, photodiodes, filters, and color converters. Diverse micro-systems, in some implementations, provide the ability for non-contact in-line and in-field diagnostics of the pixels of micro LED displays (e.g., utilizing an antenna or solar sensor in each micro-system). Additionally, the same features provide wireless I/O and power I/O.

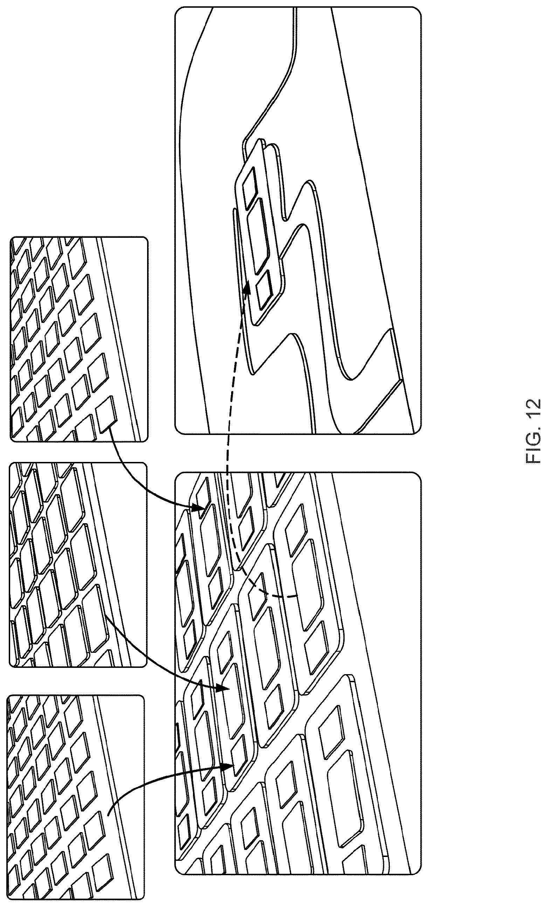

FIG. 12 is an illustration of compound micro-assembly for phased-array applications. Compound micro-assembly benefits manufacturing flows for phased-array applications. In these examples, micro-assembly techniques form micro-systems from diverse micro components selected from power amplifiers, low-noise amplifiers, analog-digital converters, transmit/receive switches, phase shifters, and frequency converters. A second micro-assembly process forms arrays of the micro-systems on a phased-array device substrate for integration with the radiating elements (antennae) of the phased array.

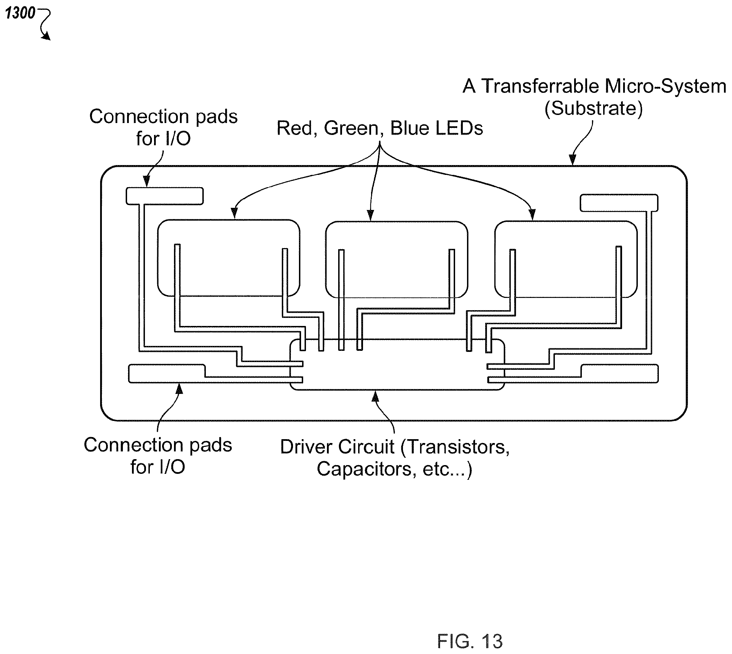

FIG. 13 is an illustration of an example micro-assembled micro-system 1300 that is a display pixel. In this example, the micro-system includes a red micro LED, a green micro LED, a blue micro LED, and a micro-integrated circuit (e.g., driver circuit). In some implementations, the micro-system for the display may include a yellow micro LED, sensors, or redundant micro LEDs. The interconnections are formed using fine lithography (e.g., fine interconnections with a width of 100 nm to 10 µm. The micro-system may include connection pads for input/output during testing or in the final display after the micro-system is transferred to the destination. After the micro-system is printed to the destination substrate (e.g., glass, plastic, sapphire, resin, epoxy, glass-reinforced epoxy laminates, or FR4), crude lithography, for example having feature sizes greater than 10 microns, is used to wire the micro-systems to form a display (e.g., crude lithography interconnections with a width from 10 µm to 2 mm).

The display may be, for example, a Quarter-VGA, 4K, and/or HD display. The number of pixels in the display (and hence micro-systems) may vary on the type of display produced. For example, the display may include 76,800 pixels, 9,437,184 pixels, or other amounts of pixels found in standard display sizes, such as NTSC or the various highdefinition standards. The number of micro LEDs will also vary based on the size of the display and whether there are redundant micro LEDs, however, example displays may include 460,800 micro LEDs or 56,623,104 micro LEDs or other standard display sizes including full-color redundant pixels. Each pixel may have a width or height of 10 µm to 1,000 µm.

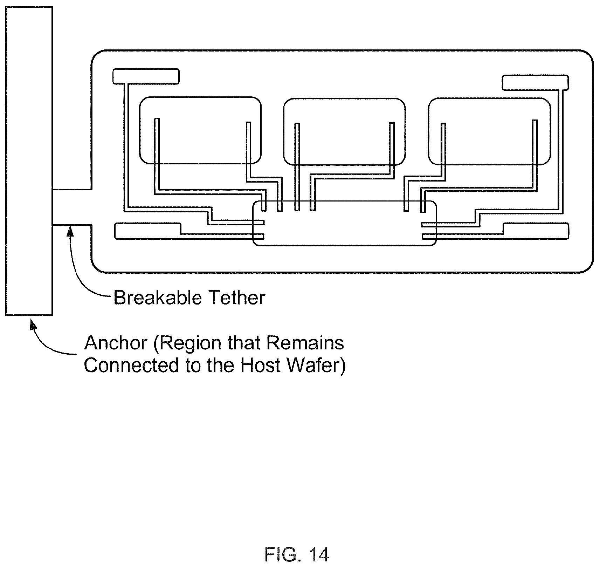

FIG. 14 is a plan view illustration of an example micro-system that has been etched underneath the micro-system and remains attached to an anchor by a breakable tether. The breakable tether is designed to break when the micro-system is picked up by a transfer device. In some implementations, the micro-system is connected to the anchor with multiple breakable tethers. In other implementations, a single tether (e.g., single, off-center tether) connects the micro-system to the anchor. In some implementations, the micro-system is connected to multiple anchors.

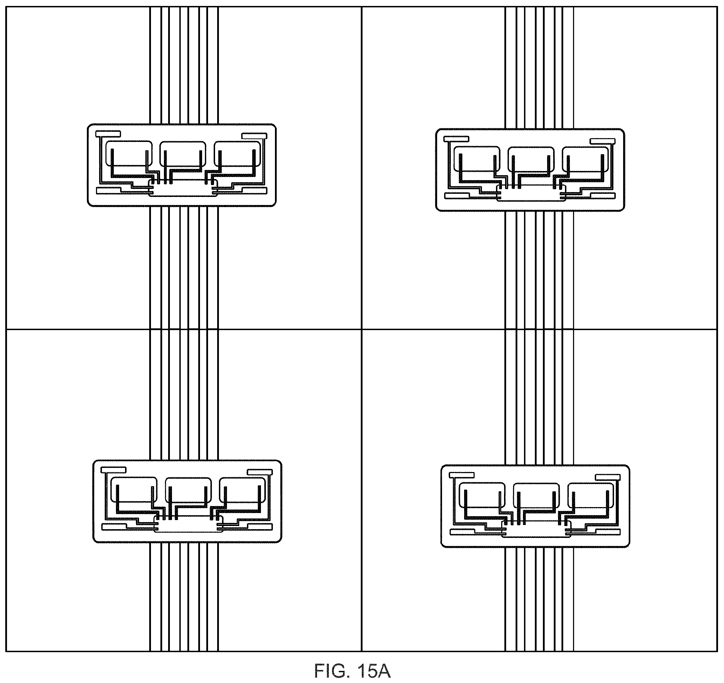

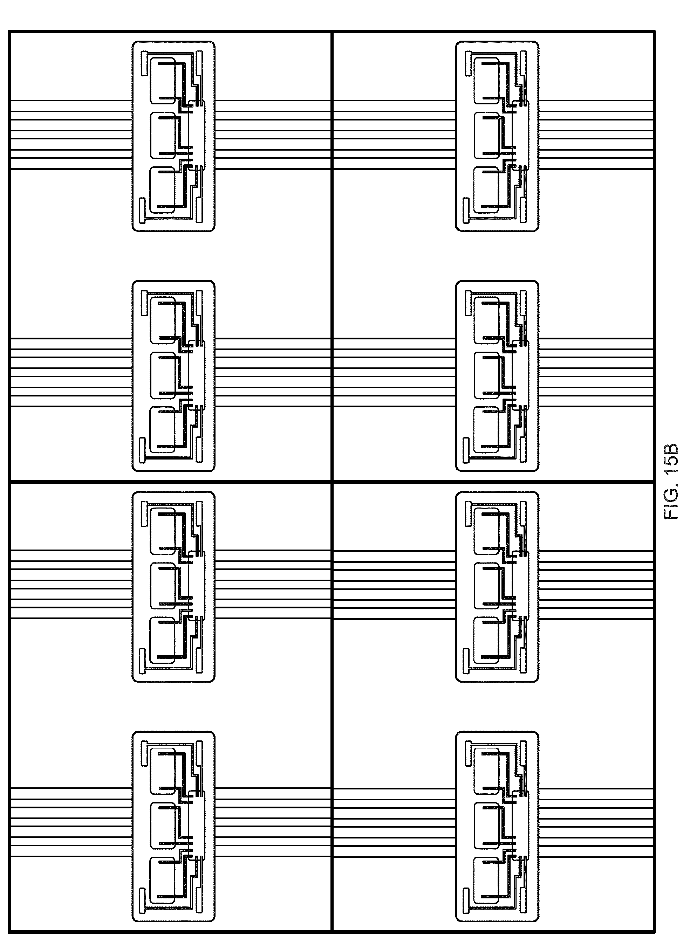

FIGS. 15A-15B are an example of micro-systems that have been printed to a destination substrate. The micro-systems are wired using relaxed metallization features (e.g. crude lithography). In contrast, the micro-systems utilize much finer wafer-level interconnects as discussed above (e.g., 100 nm - 10 µm. This combination of fine (wafer-level) interconnection features and larger panel-level interconnection features is enabled by this compound micro-assembly strategy. For example, in some implementations, fine lithography is used to wire each micro-system and then crude lithography is used to wire the micro-systems after they are printed to the destination substrate (e.g., macro-system substrate). As shown in FIG. 15B, micro-systems may be arranged in a redundant arrangement. All of the micro-systems (including the redundant micro-systems) may be wired at the same time. In some implementations, the redundant micro-systems may be wired after testing for defective micro-systems. Defective micro-systems may be repaired by wiring an adjacent redundant micro-system.

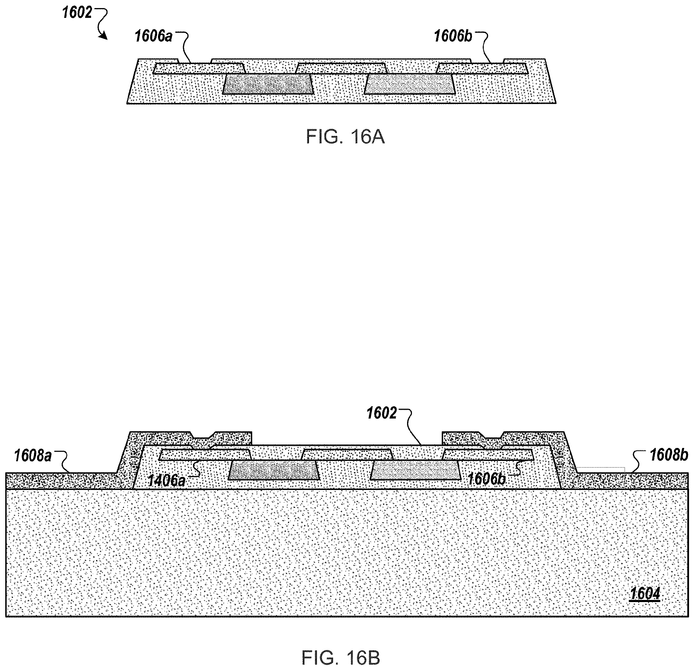

FIG. 16A is an illustration of a micro-system 1602 and FIG. 16B is an illustration of the micro-system 1602 micro-assembled on a substrate 1604 (e.g., the backplane; e.g., glass, plastic, sapphire). In this example, the micro-device 1602 includes terminals 1606a-b that are exposed on the top of the micro-system 1602 such that the micro-device 1602 is interconnected by lines 1608a-b after the micro-device 1602 is transferred to the substrate 1604. The terminals 1606a-b may be formed using fine lithography and the lines 1608a-b may be formed by crude lithography as described above.

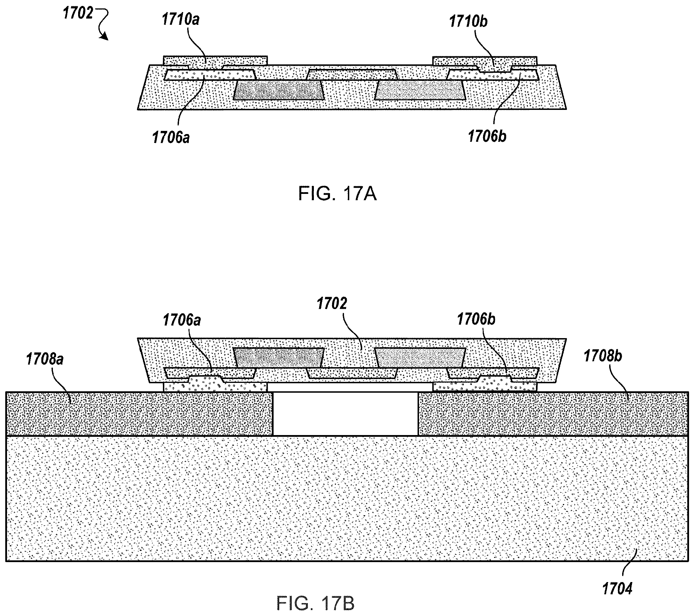

FIG. 17A is an illustration of a micro-system 1702 and FIG. 17B is an illustration of the micro-system 1702 micro-assembled on a substrate 1704 (e.g., the backplane; e.g., glass, plastic, sapphire). In this example, the micro-device 1702 includes terminals 1706a-b that are electrically coupled to connection pads 1710a-b on the top of the micro-system 1702. The interconnection lines 1708a-b are formed on the substrate 1704 prior to micro-assembling the micro-system 1702 thereon. The micro-device 1702 is inverted and transferred to the substrate 1704 such that connections pads 1710a-b are electrically coupled to the interconnection lines 1708a-b. This configuration allows the large area/crude lithography to be performed first, prior to transferring the micro-system 1702. Additionally, the macro-system shown in FIG. 17B is testable as soon as the micro-system 1702 is transferred to the substrate 1704. Moreover, in some implementations, the micro-system may be pulled off and replaced if there is a failure at the panel level.

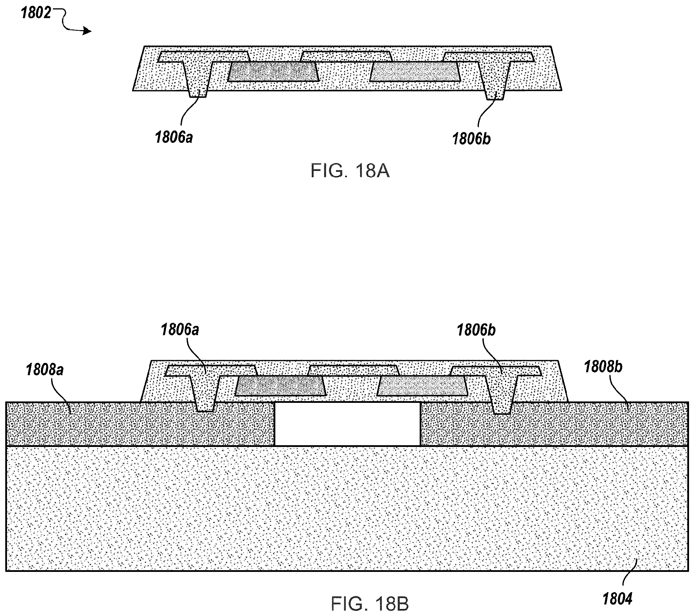

FIG. 18A is an illustration of a micro-system 1802 and FIG. 18B is an illustration of the micro-system 1802 micro-assembled on a substrate 1804 (e.g., the backplane; e.g., glass, plastic, sapphire). In this example, the micro-device 1802 includes terminals 1806a-b exposed on the bottom surface of the micro-system 1802. The interconnection lines 1808a-b are formed on the substrate 1804 prior to micro-assembling the micro-system 1802 thereon. The micro-device 1802 is transferred to the substrate 1804 such that terminals 1806a-b are electrically coupled to the interconnection lines 1808a-b.

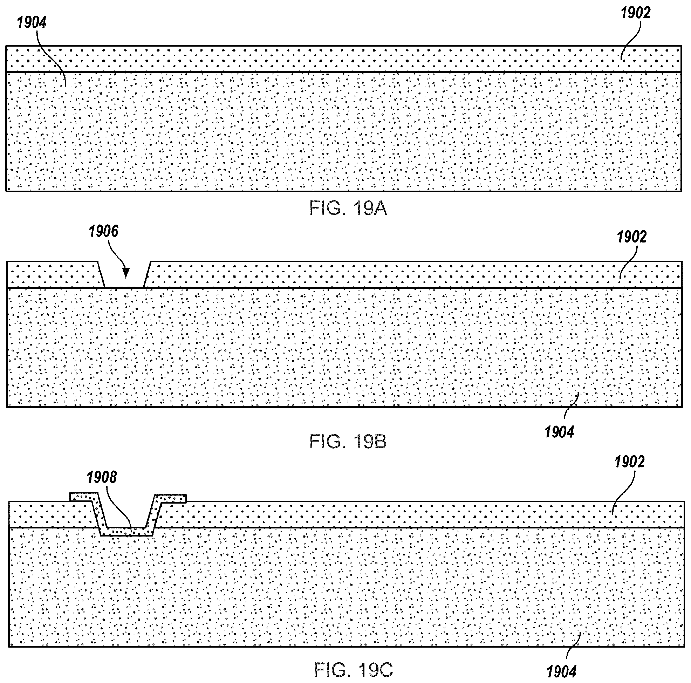

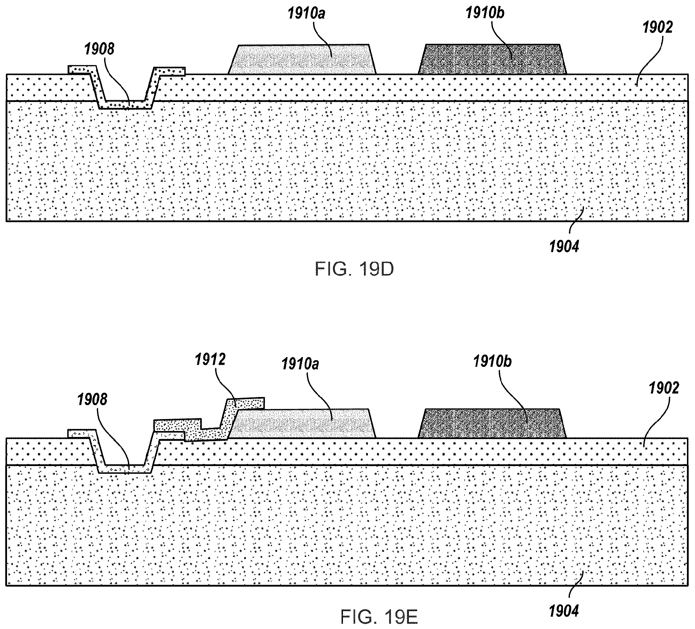

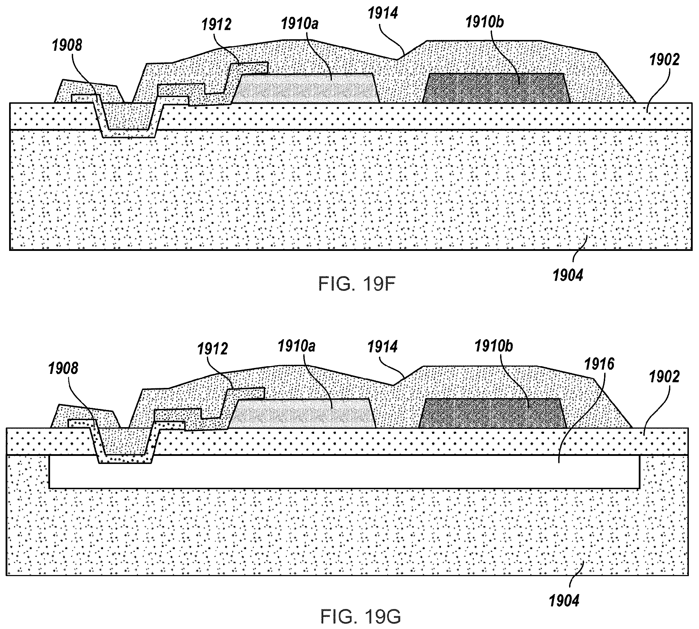

FIGS. 19A-G illustrate an example process for creating a micro-system. Wafer 1904 can be provided with an intermediate substrate 1902 (e.g., glass, plastic, a polymer film, or a polymer wafer) formed thereon as shown in FIG. 19A. In some implementations, the intermediate substrate 1902 and wafer 1904 are formed of the same material. A portion of the intermediate substrate 1902 and wafer 1904 are removed as shown in FIG. 19B, thereby leaving a well 1906. The well 1906 is coated with a conductive material to form a connection pad 1908 as shown in FIG. 19C. The connection pad 1908 can be used to connect a micro-device in the micro-system to a conductive line on the macro-system after the micro-system is transferred to the destination substrate. As shown in FIG. 19D, micro-devices 1910a-b are deposited by micro-assembly on the intermediate substrate 1902. In this example, the micro-device 1910a is electrically coupled to the connection pad 1908 by a fine conductive line 1912, as shown in Fig. 19E. This line may be formed using fine lithography as described above. The connection pad 1908, fine conductive line 1912, and micro-devices 1910a-b may be covered by an encapsulation layer 1914 (Fig. 19F). The encapsulation layer 1914 may provide a variety of functionality, including protecting the micro-system or providing a surface that facilitates micro-transfer printing the micro-system to the destination substrate. As shown in FIG. 19G, the area below the micro-system (e.g., a portion of the wafer 1904) may be etched such that the micro-system is prepared to be micro-assembled on the destination substrate. Additionally, a portion 1916 of the intermediate substrate 1902 may be etched such that the micro-system is only attached to the wafer 1904 by one or more anchors and one or more tethers (e.g., formed of a portion of the intermediate substrate). Furthermore, the etching can expose the connection pad 1908 so that the connection pad 1908 can electrically connect to a contact pad when the micro-system is micro-transfer printed on the destination substrate.

Having described various embodiments of the disclose technology, it will now become apparent to one of skill in the art that other embodiments incorporating the concepts may be used.

Throughout the description, where apparatus and systems are described as having, including, or comprising specific components, or where processes and methods are described as having, including, or comprising specific steps, it is contemplated that, additionally, there are apparatus and systems of the disclosed technology that consist essentially of, or consist of, the recited components, and that there are processes and methods according to the disclosed technology that consist essentially of, or consist of, the recited processing steps.

## Claims

1. A compound micro-assembled device comprising:
a plurality of printed micro-systems disposed on and non-native to a destination substrate, wherein each micro-system of the plurality of printed micro-systems comprises:
a plurality of micro-devices disposed on and non-native to an intermediate substrate, and
**characterised in that** each micro-system further comprises one or more fine lithography interconnections having a width of 100 nm to 1µm on the intermediate substrate, the one or more fine lithography interconnections electrically connecting the plurality of micro-devices on the intermediate substrate; and
**in that** the device is further comprising one or more crude lithography interconnections disposed on the destination substrate having a width from 2 µm to 2mm, wherein each crude lithography interconnection is electrically connected to at least one of the plurality of micro-systems on the intermediate substrate.

2. The device of claim 1, wherein the plurality of micro-devices comprises:
a red micro inorganic light emitting diode,
a green micro inorganic light emitting diode,
a blue micro inorganic light emitting diode, and
a micro-integrated circuit.

3. The device of claim 2, wherein each micro-system is a display pixel.

4. The device of any one of claims 1 to 3, comprising over 300,000 micro inorganic light-emitting diodes.

5. The device of claim 1, wherein the plurality of micro-devices comprises:
a) a power amplifier (e.g., GaN),
a phase shifter (e.g., GaAs), and
a micro-integrated circuit (e.g., silicon control circuit);
b) at least one member selected from the group consisting of: a low-noise amplifier (e.g., InP), power amplifiers, analog-digital converters, transmit/receive switches, phase shifters, and frequency converters; or
c) a detector (e.g., photodiode, photoconductor), and
a micro-integrated circuit (e.g., control/read-out circuit, e.g., silicon control circuit).

6. The device of any one of claims 1 to 5, wherein the destination substrate is a member selected from the group consisting of polymer, plastic, resin, polyimide, PEN, PET, metal, metal foil, glass, a semiconductor, and sapphire.

7. The device of any one of claims 1 to 6, wherein the device comprises a matrix of at least 50,000 micro-systems on the destination substrate.

8. The device of any one of claims 1 to 7, wherein the destination substrate has a transparency greater than or equal to 50%, 80%, 90%, or 95% for visible light.

9. The device of any one of claims 1 to 8, wherein the destination substrate has a contiguous substrate area, the plurality of micro devices each have a device area, and the combined device areas of the plurality of micro devices is less than or equal to one-quarter of the contiguous substrate area.

10. The device of claim 9, wherein the combined device areas of the plurality of micro devices is less than or equal to one eighth, one tenth, one twentieth, one fiftieth, one hundredth, one five-hundredth, one thousandth, one two-thousandth, or one ten-thousandth of the contiguous substrate area.

11. The device of any one of claims 1 to 10, wherein each of the plurality of micro devices has at least one of a length, width, and height from 2 to 5 µm, 5 to 10 µm, 10 to 20 µm, or 20 to 50 µm.

12. The device of any one of claims 1 to 11, wherein the destination substrate has a thickness from 5 to 10 microns, 10 to 50 microns, 50 to 100 microns, 100 to 200 microns, 200 to 500 microns, 500 microns to 0.5 mm, 0.5 to 1 mm, 1 mm to 5 mm, 5 mm to 10 mm, or 10 mm to 20 mm.

## Patentansprüche

1. Vorrichtung mit mikrogefertigten Verbindungen, umfassend:
eine Vielzahl von gedruckten Mikrosystemen, die auf einem Zielsubstrat angeordnet und nicht nativ zu diesem sind, wobei jedes Mikrosystem der Vielzahl von gedruckten Mikrosystemen Folgendes umfasst:
eine Vielzahl von Mikrovorrichtungen, die auf einem Zwischensubstrat angeordnet und nicht nativ zu diesem sind, und
**dadurch gekennzeichnet, dass** jedes Mikrosystem ferner eine oder mehrere feine lithografische Zwischenverbindungen umfasst, die eine Breite von 100 nm bis 1 µm auf dem Zwischensubstrat aufweisen, wobei die eine oder mehrere feinen lithografischen Zwischenverbindungen die Vielzahl von Mikrovorrichtungen auf dem Zwischensubstrat elektrisch verbinden; und
dass die Vorrichtung ferner Folgendes umfasst:
eine oder mehrere grobe Lithographiezwischenverbindungen, die auf dem Zielsubstrat angeordnet sind und eine Breite von 2 µm bis 2 mm aufweisen, wobei jede grobe Lithographiezwischenverbindung elektrisch mit mindestens einem der mehreren Mikrosysteme auf dem Zwischensubstrat verbunden ist.

2. Vorrichtung nach Anspruch 1, wobei die Vielzahl von Mikrovorrichtungen Folgendes umfasst:
eine rote mikro-anorganische lichtemittierende Diode,
eine grüne mikro-anorganische lichtemittierende Diode,
eine blaue mikro-anorganische lichtemittierende Diode, und
eine mikrointegrierte Schaltung.

3. Vorrichtung nach Anspruch 2, wobei jedes Mikrosystem ein Anzeigepixel ist.

4. Vorrichtung nach einem der Ansprüche 1 bis 3, umfassend über 300.000 mikro-anorganische lichtemittierende Dioden.

5. Vorrichtung nach Anspruch 1, wobei die Vielzahl von Mikrovorrichtungen Folgendes umfasst:
a) einen Leistungsverstärker (z. B. GaN),
einen Phasenschieber (z. B. GaAs) und
eine mikrointegrierte Schaltung (z. B. eine Siliziumsteuerschaltung);
b) mindestens ein Element, ausgewählt aus der Gruppe, bestehend aus: einem rauscharmen Verstärker (z. B. InP), Leistungsverstärkern, Analog-Digital-Wandlern, Sende-/Empfangsschaltern, Phasenschiebern und Frequenzwandlern; oder
c) einen Detektor (z. B. Fotodiode, Fotoleiter) und
eine mikrointegrierte Schaltung (z. B. Steuer-/Ausleseschaltung, z. B. Siliziumsteuerschaltung).

6. Vorrichtung nach einem der Ansprüche 1 bis 5, wobei das Zielsubstrat ein Element ist, das aus der Gruppe ausgewählt ist, bestehend aus Polymer, Kunststoff, Harz, Polyimid, PEN, PET, Metall, Metallfolie, Glas, einem Halbleiter und Saphir.

7. Vorrichtung nach einem der Ansprüche 1 bis 6, wobei die Vorrichtung eine Matrix aus mindestens 50.000 Mikrosystemen auf dem Zielsubstrat umfasst.

8. Vorrichtung nach einem der Ansprüche 1 bis 7, wobei das Zielsubstrat eine Transparenz von größer oder gleich 50 %, 80 %, 90 % oder 95 % für sichtbares Licht aufweist.

9. Vorrichtung nach einem der Ansprüche 1 bis 8, wobei das Zielsubstrat einen zusammenhängenden Substratbereich aufweist, die mehreren Mikrovorrichtungen jeweils einen Vorrichtungsbereich aufweisen und die kombinierten Vorrichtungsbereiche der mehreren Mikrovorrichtungen weniger als oder gleich einem Viertel des zusammenhängenden Substratbereichs betragen.

10. Vorrichtung nach Anspruch 9, wobei die kombinierten Vorrichtungsbereiche der Vielzahl von Mikrovorrichtungen weniger als oder gleich einem Achtel, einem Zehntel, einem Zwanzigstel, einem Fünfzigstel, einem Hundertstel, einem Fünfhundertstel, einem Tausendstel, einem Zweitausendstel oder einem Zehntausendstel des zusammenhängenden Substratbereichs sind.

11. Vorrichtung nach einem der Ansprüche 1 bis 10, wobei jede der mehreren Mikrovorrichtungen mindestens eine Länge, Breite und Höhe von 2 bis 5 µm, 5 bis 10 µm, 10 bis 20 µm oder 20 bis 50 µm aufweist.

12. Vorrichtung nach einem der Ansprüche 1 bis 11, wobei das Zielsubstrat eine Dicke von 5 bis 10 Mikron, 10 bis 50 Mikron, 50 bis 100 Mikron, 100 bis 200 Mikron, 200 bis 500 Mikron, 500 Mikron bis 0,5 mm, 0,5 bis 1 mm, 1 mm bis 5 mm, 5 mm bis 10 mm oder 10 mm bis 20 mm aufweist.

## Revendications

1. Dispositif composite micro-assemblé, comprenant :
une pluralité de micro-systèmes imprimés disposés sur un substrat de destination et non natifs de celui-ci, dans lequel chaque micro-système de la pluralité de micro-systèmes imprimés comprend :
une pluralité de micro-dispositifs disposés sur un substrat intermédiaire et non natifs de celui-ci, et
**caractérisé en ce que** chaque micro-système comprend également
une ou plusieurs interconnexions de lithographie fine ayant une largeur de 100 nm à 1 µm sur le substrat intermédiaire, l'une ou les plusieurs interconnexions de lithographie fines connectant électriquement la pluralité de micro-dispositifs sur le substrat intermédiaire ; et
**en ce que** le dispositif comprend également
une ou plusieurs interconnexions de lithographie brutes disposées sur le substrat de destination ayant une largeur de 2 µm à 2 mm, dans lequel chaque interconnexion de lithographie brute est connectée électriquement à au moins l'un de la pluralité de micro-systèmes sur le substrat intermédiaire.

2. Dispositif selon la revendication 1, dans lequel la pluralité de micro-dispositifs comprend :
une micro-diode électroluminescente inorganique rouge,
une micro-diode électroluminescente inorganique verte,
une micro-diode électroluminescente inorganique bleue, et
un circuit micro-intégré.

3. Dispositif selon la revendication 2, dans lequel chaque micro-système est un pixel d'affichage.

4. Dispositif selon l'une quelconque des revendications 1 à 3, comprenant plus de 300 000 microdiodes électroluminescentes inorganiques.

5. Dispositif selon la revendication 1, dans lequel la pluralité de micro-dispositifs comprend :
a) un amplificateur de puissance (par exemple, GaN),
un déphaseur (par exemple, GaAs), et
un circuit micro-intégré (par exemple, un circuit de commande en silicium) ;
b) au moins un élément choisi parmi le groupe constitué de : un amplificateur à faible bruit (par exemple, InP), des amplificateurs de puissance, des convertisseurs analogiques-numériques, des commutateurs d'émission/réception, des déphaseurs et des convertisseurs de fréquence ; ou
c) un détecteur (par exemple, une photodiode, un photoconducteur), et
un circuit micro-intégré (par exemple, un circuit de commande/lecture, par exemple, un circuit de commande en silicium).

6. Dispositif selon l'une quelconque des revendications 1 à 5, dans lequel le substrat de destination est un élément choisi parmi le groupe constitué d'un polymère, d'un plastique, d'une résine, d'un polyimide, d'un PEN, d'un PET, d'un métal, d'une feuille métallique, d'un verre, d'un semi-conducteur et d'un saphir.

7. Dispositif selon l'une quelconque des revendications 1 à 6, dans lequel le dispositif comprend une matrice d'au moins 50 000 micro-systèmes sur le substrat de destination.

8. Dispositif selon l'une quelconque des revendications 1 à 7, dans lequel le substrat de destination a une transparence supérieure ou égale à 50 %, 80 %, 90 % ou 95 % pour la lumière visible.

9. Dispositif selon l'une quelconque des revendications 1 à 8, dans lequel le substrat de destination a une zone de substrat contiguë, la pluralité de micro-dispositifs a chacun une zone de dispositif, et les zones de dispositif combinées de la pluralité de micro-dispositifs sont inférieures ou égales à un quart de la zone de substrat contiguë.

10. Dispositif selon la revendication 9, dans lequel les zones de dispositif combinées de la pluralité de micro-dispositifs sont inférieures ou égales à un huitième, un dixième, un vingtième, un cinquantième, un centième, un cinq centième, un millième, un deux millième ou un dixmillième de la zone de substrat contiguë.

11. Dispositif selon l'une quelconque des revendications 1 à 10, dans lequel chacun de la pluralité de micro-dispositifs présente au moins l'une d'une longueur, d'une largeur et d'une hauteur de 2 à 5 µm, de 5 à 10 µm, de 10 à 20 µm ou de 20 à 50 µm.

12. Dispositif selon l'une quelconque des revendications 1 à 11, dans lequel le substrat de destination a une épaisseur de 5 à 10 microns, de 10 à 50 microns, de 50 à 100 microns, de 100 à 200 microns, de 200 à 500 microns, de 500 microns à 0,5 mm, de 0,5 à 1 mm, de 1 mm à 5 mm, de 5 mm à 10 mm ou de 10 mm à 20 mm.
